# EUROPÄISCHE PATENTSCHRIFT

(11) **EP 0 502 242 B1**
(45) Veröffentlichungstag und Bekanntmachung des Hinweises auf die Patenterteilung: **27.08.1997**
(21) Anmeldenummer: 91116294.9
(22) Anmeldetag: 25.09.1991
(51) Int. Cl.: C23C 14/35, H01J 37/34, C23C 14/06, C23C 14/08, C23C 14/54

(54) **Reaktive Zerstäubungsvorrichtung**
Reactive sputtering apparatus
Dispositif pour pulverisation réactif

(30) Priorität: 04.03.1991 DE 4106770
(43) Veröffentlichungstag der Anmeldung: 09.09.1992
(73) Patentinhaber: Balzers und Leybold Deutschland Holding Aktiengesellschaft, 63450 Hanau (DE)
(72) Erfinder: Latz, Rudolf, Dr., W-6054 Rodgau 2 (DE); Schanz, Michael, Dr., W-6054 Rodgau 1 (DE); Scherer, Michael, Dr., W-6458 Rodenbach (DE); Szczyrbowski, Jochaim, Dr., W-8758 Goldbach (DE)

(56) Entgegenhaltungen:
- EP-A- 0 411 359
- DD-A- 252 205
- DE-A- 3 802 852
- GB-A- 1 172 106
- US-A- 4 166 784

## Beschreibung

Die Erfindung betrifft eine Vorrichtung zum reaktiven Beschichten eines Substrats mit einem elektrisch isolierenden Werkstoff, beispielsweise mit Siliziumdioxid (SiO₂), bestehend aus einer Wechselstromquelle, die mit in einer evakuierbaren Beschichtungskammer angeordneten Magnetronkathoden verbunden ist, deren Targets zerstäubt werden und deren zerstäubte Teilchen sich auf dem Substrat niederschlagen, wobei zwei erdfreie Ausgänge der Wechselstromquelle mit je einer Magnetronkathode verbunden sind, wobei beide Magnetronkathoden in einer Beschichtungskammer nebeneinander liegend in einem Plasmaraum vorgesehen sind und zum gegenüberliegenden Substrat jeweils etwa den gleichen räumlichen Abstand aufweisen.

Bei bekannten Verfahren zum Beschichten von Substraten mit Hilfe von Kathodenzerstäubung und Materialien mit einer hohen Affinität zum Reaktivgas besteht das Problem, daß neben dem Substrat selbst auch Teile der Vorrichtung - wie die Innenwand der Prozeßkammer oder Teile von Blenden oder die Targetoberfläche - mit elektrisch nicht- oder schlechtleitenden Materialien beschichtet werden, was die häufige Änderung der Prozeßparameter zur Folge hat und insbesondere auch zu elektrischen Überschlägen führt, so daß eine häufige Unterbrechung des Prozesses und auch eine häufige Reinigung oder ein Austausch von Teilen der Vorrichtung erforderlich wird.

Es ist bereits eine mit Radiofrequenz - vorzugsweise mit 13,56 MHz - arbeitende Sputtervorrichtung bekannt (US-A 3,860,507), bei der in der Prozeßkammer zwei einander diametral gegenüberliegende Targets vorgesehen sind, die jeweils über Elektroden mit den beiden Ausgängen der Sekundärwicklung eines Wechselstromtransformators verbunden sind, wobei die Sekundärwicklung eine Mittenanzapfung aufweist, die elektrisch an die Wandung der Prozeßkammer angeschlossen ist, derart, daß sich zwischen den beiden Targets eine Glimmentladung ausbildet.

Weiterhin ist eine Einrichtung für die Beschichtung eines Substrats mit einem Material, das aus einem Plasma gewonnen wird, bekannt (DE-A- 38 02 852), wobei sich das Substrat zwischen einer ersten und einer zweiten Elektrode befindet und bei der die erste Elektrode an einem ersten Anschluß einer Wechselstromquelle und die zweite Elektrode an einem zweiten Anschluß der Wechselstromquelle liegt. Die Wechselstromquelle ist in diesem Falle als Streufeldtransformator ausgebildet, der aus einer Schutzgasschweißanlage oder einer ähnlichen geregelten Wechselstromversorgung gespeist wird. Darüberhinaus sind die beiden Elektroden wahlweise auch mit einer Gleichstromversorgung verbindbar.

Bekannt ist auch eine Zerstäubungseinrichtung (DD-A- 252 205 A1), bestehend aus einem Magnetsystem und mindestens zwei darüber angeordneten Elektroden, die aus dem zu zerstäubenden Material bestehen und so geschaltet sind, daß sie wechselweise Kathode und Anode einer Gasentladung sind, wobei die Elektroden an eine sinusförmige Wechselspannung von vorzugsweise 50 Hz angeschlossen sind. Jeder Elektrode ist dabei ein unabhängiges Magnetsystem zugeordnet, wobei ein Pol des einen Magnetsystems zugleich ein Pol des benachbarten Magnetsystems ist und die Elektroden in einer Ebene angeordnet sind.

Weiterhin ist eine Vorrichtung zum Beschichten eines Substrats mit einem elektrisch isolierenden Werkstoff bekannt (GB-A-1 172 106), bei der zwei Targetelektroden in einer evakuierbaren Beschichtungskammer angeordnet sind, wobei in die Beschichtungskammer ein Prozeßgas einbringbar ist und die Elektroden jeweils mit einer Sekundärwicklung eines Wechselstromtransformators mit Wechselstrom gespeist sind, wobei die Targetelektroden beide in der Beschichtungskammer nebeneinander liegend und im gleichen Abstand zum Substrat angeordnet sind.

Schließlich ist eine Reaktiven-Zerstäubungseinrichtung bekannt (US-A-4 166 784), bei der der Effektivwert der Entladespannung von einer über eine Leitung an die Kathode angeschlossenen Spannungseffektivwerterfassung gemessen und als Gleichspannung einem Regler über eine Leitung zugeführt wird, der über ein Regelventil den Reaktivgasfluß so steuert, daß die gemessene Spannung mit einer Sollspannung übereinstimmt.

Der vorliegenden Erfindung liegt deshalb die Aufgabe zugrunde, eine Vorrichtung zum Sputtern von Materialien mit hoher Affinität zu einem Reaktivgas zu schaffen, die einen gleichmäßigen bzw. stabilen Prozeß ermöglicht und auch bei langen Betriebszeiten störungsfrei und insbesondere überschlagsfrei arbeitet und dies bei Abscheidung isolierender Schichten, wie z. B. SiO₂, Al₂O₃, NiSi₂-Oxid, ZrO₂, TiO₂, ZnO, SnO₂, Si₃N₄, wobei diese Schichten besonders fest auf dem Substrat haften sollen.

Diese Aufgabe wird erfindungsgemäß dadurch erreicht, daß die beiden Magnetronkathoden jeweils eine eigene Verteilerleitung für das Prozeßgas besitzen und die Aufteilung des Reaktivgasflusses auf beide Verteilerleitungen von einem Regler über ein Leitwertregelventil derart gesteuert ist, daß die gemessene Spannungsdifferenz der Effektivwerte beider Kathoden mit einer Sollspannung übereinstimmt, wozu die Effektivwerte von über Leitungen (14) an die Kathoden (15) angeschlossenen Spannungseffektivwerterfassungen (20) gemessen und als Gleichspannungen dem Regler (16) über Leitungen (21) zugeführt werden.

Weitere Einzelheiten und Merkmale sind in den Patentansprüchen näher charakterisiert und gekennzeichnet.

Die anhängende Zeichnung stellt schematisch den Schnitt durch eine Sputteranlage mit zwei Magnetron-Sputterkathoden dar.

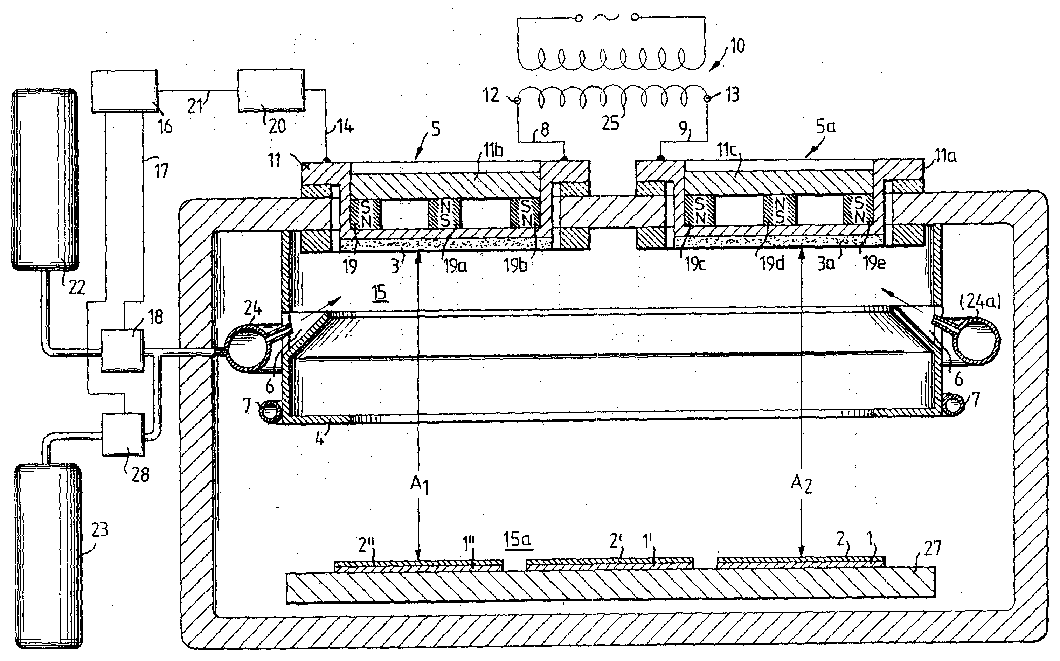

In der Zeichnung sind Substrate 1,1',1" dargestellt, die jeweils mit einer dünnen Schicht 2, 2', 2" aus einem Oxid (z. B. Siliziumdioxid oder Aluminiumoxid) versehen werden sollen. Diesen Substraten 1, 1', 1" liegen Targets 3, 3a gegenüber, die zu zerstäuben sind. Jedes Target 3, 3a ist mit einem Kathodenkörper 11, 11a verbunden, der ein Magnetjoch 11b, 11c aufnimmt, das jeweils drei Magnete 19, 19a, 19b bzw. 19c, 19d, 19e aufweist.

Die auf die Targets 3, 3a gerichteten Polaritäten der Pole der sechs Magnete wechseln sich ab, so daß jeweils die Südpole der beiden jeweils äußeren Magnete 19, 19b bzw. 19c, 19e mit dem Nordpol des jeweils innenliegenden Magneten 19a bzw. 19d etwa kreisbogenförmige Magnetfelder durch die Targets 3, 3a bewirken. Diese Magnetfelder verdichten das Plasma vor den Targets, so daß es jeweils dort, wo die Magnetfelder das Maximum ihrer Kreisbögen aufweisen, seine größte Dichte hat. Die Ionen im Plasma werden durch elektrische Felder beschleunigt, die sich aufgrund einer Wechselspannung aufbauen, die von der Stromquelle 10 abgegeben wird.

Diese Wechselstromquelle 10 weist zwei Anschlüsse 12, 13 auf, die von den Enden einer sekundären Transformatorwicklung 25 gebildet sind und an die beiden Kathoden 5, 5a angeschlossen sind. Die beiden Stromleiter 8, 9 der sekundären Transformatorwicklung sind mit den beiden Targets 3, 3a verbunden.

Das Target 3 ist außerdem über eine Leitung 14 mit einer gegen Erde geschalteten Spannungseffektivwerterfassung 20 verbunden, die wiederum über eine weitere Leitung 21 an einen Regler 16 angeschlossen ist, der seinerseits über eine Leitung 17 mit einem Leitwertregelventil 18 in Verbindung steht, das den Zufluß des im Behälter 22 befindlichen Reaktivgases in die Verteilerleitung 24 der Vakuumkammer 15, 15a kontrolliert.

Die Beschichtungskammer 15, 15a ist mit einem ring- oder rahmenförmigen Abschirmblech bzw. einer Blende 4 versehen, die einen Spalt oder Schlitz 6 aufweist, durch die das Prozeßgas aus der Verteilerleitung 24 in Pfeilrichtung in die Beschichtungskammer 15 einströmen kann. Der untere Rand der Blende 4 ist außerdem von einem Kühlrohr 7 umgriffen, das von einem Kühlmittel durchströmt ist und ein Überhitzen der Blende 4 verhindert.

Die Magnetronkathoden (5,5a) besitzen erfindungsgemäß darüber hinaus jeweils eine eigene Verteilerleitung (24,24a) für das Prozeßgas. Die Aufteilung des Reaktivgasflusses ist auf beide Verteilerleitungen (24,24a) von einem Regler (16) über ein Leitwertregelventil (18) derart gesteuert, daß die gemessene Spannungsdifferenz der Effektivwerte beider Kathoden (5,5a) mit einer Sollspannung übereinstimmt. Die Effektivwerte von über Leitungen (14) an die Kathoden (15) angeschlossenen Spannungseffektivwerterfassungen (20) werden dazu gemessen und als Gleichspannungen dem Regler (16) über Leitungen zugeführt.

Die Frequenz der Wechselstromquelle 10 ist während des Sputterprozesses so eingestellt, daß die Ionen dem Wechselfeld noch folgen können, was bei einer Frequenz von etwa 1 KHz - 100 KHz der Fall ist. Die über die Leitung 14 abgegriffene Entladespannung wird mit Hilfe der Spannungseffektivwerterfassung 20 über die Leitung 21 als Gleichspannung einem Regler 16 zugeführt, der wiederum über die Leitung 17 das Magnetventil 18 für die Zuführung des Reaktivgases ansteuert und zwar derart, daß die gemessene Spannung die erforderliche Reaktivgasmenge bestimmt.

### Bezugszeichenliste

- 1, 1', 1": Substrat
- 2, 2', 2": Schicht
- 3, 3a: Targets
- 4: Blende
- 5, 5a: Kathode
- 6: Schlitz
- 7: Kühlrohr
- 8: Stromleiter
- 9: Stromleiter
- 10: Wechselstromquelle, Wechselstromspannungsversorgung
- 11, 11a: Kathodenkörper
- 11b, 11c: Magnetjoch
- 12: Stromanschluß
- 13: Stromanschluß
- 14: Leitung
- 15: Plasmaraum
- 15a: Beschichtungskammer, Rezipient
- 16: Regler
- 17: Leitung
- 18: Regelventil
- 19, 19a, 19b 19c, 19d, 19e: Magnet
- 20: Spannungseffektivwerterfassung
- 21: Leitung
- 22: Behälter für Reaktivgas
- 23: Behälter für Inertgas (z. B. Argon)
- 24: Verteilerleitung
- 25: Sekundäre Transformatorwicklung
- 26: Vakuumkammer
- 27: Substrat-Carrier
- 28: Flow-Regler

## Patentansprüche

1. Vorrichtung zum reaktiven Beschichten eines Substrats (1, 1', 1",) mit einem elektrisch isolierenden Werkstoff, beispielsweise mit Siliziumdioxid (SiO₂), bestehend aus einer Wechselstromquelle (10), die mit in einer evakuierbaren Beschichtungskammer (15, 15a) angeordneten Magnetronkathoden (5, 5a) verbunden ist, deren Targets (3, 3a) zerstäubt werden und deren zerstäubte Teilchen sich auf dem Substrat (1, 1', 1") niederschlagen, wobei zwei erdfreie Ausgänge (12, 13) der Wechselstromquelle (10) mit je einer Magnetronkathode (5, 5a) verbunden sind, die beide in einer Beschichtungskammer (15, 15a) nebeneinanderliegend vorgesehen sind und zum gegenüberliegenden Substrat (1, 1', 1") jeweils etwa den gleichen räumlichen Abstand (A₁ bzw. A₂) aufweisen, dadurch gekennzeichnet, daß die Magnetronkathoden (5, 5a) jeweils eine eigene Verteilerleitung (24, 24a) für das Prozeßgas besitzen und die Aufteilung des Reaktivgasflusses auf beide Verteilerleitungen (24, 24a) von einem Regler (16) über ein Leitwertregelventil (18) derart gesteuert ist, daß die gemessene Spannungsdifferenz der Effektivwerte beider Kathoden (5, 5a) mit einer Sollspannung übereinstimmt - wozu die Effektivwerte der über Leitungen (14) an die Kathoden (15) angeschlossenen Spannungseffektivwerterfassungen (20) gemessen und als Gleichspannungen dem Regler (16) über Leitungen (21) zugeführt werden.

## Claims

1. A device for the reactive coating of a substrate (1, 1', 1") with an electrically insulating material, for example silicon dioxide (SiO₂), comprising an a.c. source (10) which is connected to magnetron cathodes (5, 5a), which are arranged in an evacuatable coating chamber (15, 15a) and whose targets (3, 3a) are sputtered and the sputtered particles of which are deposited on the substrates (1, 1', 1"), wherein two earth-free outputs (12, 13) of the a.c. source (10) are each connected to a magnetron cathode (5, 5a), the two magnetron cathodes being arranged one beside another in a coating chamber (15, 15a) and in each case spaced by approximately the same distance (A₁ and A₂) from the oppositely disposed substrate (1, 1', 1"), characterised in that the magnetron cathodes (5, 5a) each have an individual distributor pipeline (24, 24a) for the process gas, and the division of the reactive gas flow between the two distributor pipelines (24, 24a) is controlled by a regulating device (16) via a conductance regulating valve (18) in such manner that the measured voltage difference of the effective values of the two cathodes (5, 5a) corresponds to a setpoint voltage, for which purpose the effective values of the voltage effective value detectors (20) connected via lines (14) to the cathodes (15) are measured and fed via lines (21) as d.c. voltages to the regulating device (16).

## Revendications

1. Dispositif d'enduction réactive d'un substrat (1, 1', 1") avec une substance électriquement isolante, par exemple du dioxyde de silicium (SiO₂), constitué par une source de courant alternatif (10), qui est reliée à des cathodes de magnétron (5, 5a) agencées dans une chambre d'enduction (15, 15a) susceptible d'être évacuée, dont les cibles (3, 3a) sont pulvérisées et dont les particules pulvérisées se déposent sur le substrat (1, 1', 1"), deux sorties (12, 13) isolées de la terre de la source de courant alternatif (10) étant reliées avec des cathodes de magnétron (5, 5a) respectives qui sont toutes les deux prévues l'une à côté de l'autre dans une chambre d'enduction (15, 15a) et qui présentent par rapport au substrat (1, 1', 1"), situé en face, approximativement le même écartement respectif dans l'espace (A₁, A₂), caractérisé en ce que les cathodes de magnétron (5, 5a) possèdent chacune une propre conduite de distribution (24, 24a) pour le gaz de traitement, et en ce que la répartition du flux de gaz réactif sur les deux conduites de distribution (24, 24a) est commandée par un régulateur (16) par l'intermédiaire d'une soupape de réglage de la susceptance (18) de telle sorte que la différence de tension mesurée des valeurs efficaces des deux cathodes (5, 5a) concorde avec une tension de consigne - et dans ce but, les valeurs efficaces des appareils mesureurs de valeurs efficaces de tension (20) branchés aux cathodes (15) par l'intermédiaire de deux lignes (14) sont mesurées et amenées sous forme de tensions continues au régulateur (16) par l'intermédiaire de lignes (21).
